# EUROPEAN PATENT APPLICATION

(11) **EP 4 682 939 A1**
(43) Date of publication of application: **21.01.2026**
(21) Application number: 24770642.7
(22) Date of filing: 05.03.2024
(51) Int. Cl.: H01L 21/304, B24B 37/00, C09G 1/02, C09K 3/14

(54) **POLISHING COMPOSITION, CONCENTRATED LIQUID OF POLISHING COMPOSITION, AND POLISHING METHOD**

(30) Priority: 14.03.2023 JP 2023039981
(71) Applicant: Fujimi Incorporated, Kiyosu-shi, Aichi 452-8502 (JP)
(72) Inventor: MUKAI, Takatoshi, Kiyosu-shi, Aichi 452-8502 (JP); NUMATA, Keisuke, Kiyosu-shi, Aichi 452-8502 (JP); MURASE, Takehiko, Kiyosu-shi, Aichi 452-8502 (JP); ASADA, Maki, Kiyosu-shi, Aichi 452-8502 (JP); TSUCHIYA, Kohsuke, Kiyosu-shi, Aichi 452-8502 (JP)
(74) Representative: Grünecker Patent- und Rechtsanwälte PartG mbB
(86) International application number: PCT/JP2024/008253
(87) International publication number: WO 2024/190532

(57) **Abstract**

The present invention provides a polishing composition capable of improving the surface quality of an object to be polished after polishing. The present disclosure relates to the polishing composition comprising (A) an abrasive, (B) Compound α having a polyethylene oxide structure and a polypropylene oxide structure, (C) a water soluble polymer different from the Compound α, (D) a basic compound, and (E) a dispersion medium, wherein (B) the Compound α is contained in an amount of 0.0001 mass% or more relative to the total mass of the polishing composition, and the ratio of the total mass of (B) the Compound α and (C) the water soluble polymer to the mass of (A) the abrasive, [{(B)+(C)}/(A)], is 0.058 or more and less than 0.150.

## Description

### TECHNICAL FIELD

The present invention relates to a polishing composition, a concentrated liquid of the polishing composition, and a polishing method.

### BACKGROUND ART

In order to realize highly integrated and high-speed integrated circuits such as ULSI used in computers, the design rules for semiconductor devices are becoming increasingly miniaturized year by year. In response, there are an increasing number of cases where more minute surface defects on semiconductor wafers adversely affect the performance of semiconductor devices, and it is becoming increasingly important to control nano-order defects, which have not been previously considered a problem.

For example, Japanese Patent No. 4668528 (corresponding to the specification of U.S. Patent Application Publication No. 2005/054203) discloses that a polishing composition containing abrasives, a block polyether of polyethylene oxide and polypropylene oxide, a basic compound, at least one selected from hydroxyethyl cellulose and polyvinyl alcohol, and water improves the polishing removal rate for silicon wafers and improves the surface quality after polishing.

### SUMMARY OF INVENTION

However, as described above, in the current situation where higher quality is becoming demanded, the surface quality of semiconductor wafers is required to be at a higher level than that of the technology described in Japanese Patent No. 4668528 (corresponding to the specification of U.S. Patent Application Publication No. 2005/054203). Specifically, the level of the surface quality of semiconductor wafers obtained by the production methods using conventional polishing compositions is becoming inadequate in today's world, where the quality required of semiconductor wafers is becoming increasingly demanding as semiconductor devices achieve higher performance and higher integration density.

The present invention was made in view of these circumstances, and its object is to provide a means by which the surface quality of an object to be polished after polishing can be improved.

One aspect that can solve the above-mentioned problem of the present invention is a polishing composition comprising (A) an abrasive, (B) Compound α having a polyethylene oxide structure and a polypropylene oxide structure, (C) a water soluble polymer different from the Compound α, (D) a basic compound, and (E) a dispersion medium, wherein (B) the Compound α is contained in an amount of 0.0001 mass% or more relative to the total mass of the polishing composition, and the ratio of the total mass of (B) the Compound α and (C) the water soluble polymer to the mass of (A) the abrasive, [{(B)+(C)}/(A)], is 0.058 or more and less than 0.150.

### DESCRIPTION OF EMBODIMENTS

Embodiments for implementing the present invention will be described in detail below. The embodiments described herein are examples to embody the technical concept of the present invention, and not to limit the present invention. Therefore, all other possible embodiments, methods of use, operational techniques, and the like that can be thought of by those skilled in the art without deviating from the essence of the present invention are all included in the scope and essence of the present invention, as well as in the scope of the invention described in the claims and their equivalents. The embodiments described in this description can be combined arbitrarily to form other embodiments. As used herein, unless otherwise specified, operations and measurements of physical properties and the like are performed under conditions of room temperature (20°C or higher and 25°C or lower) and relative humidity of 40% RH or higher and 60% RH or lower.

One aspect of the present invention is a polishing composition comprising an abrasive, Compound α having specific structures, a water soluble polymer different from Compound α, a basic compound, and a dispersion medium. In the polishing composition according to the present aspect, Compound α is contained in a specific amount, and the components are blended so that the ratio of the total mass of Compound α and the water soluble polymer to the mass of the abrasive is within a specific range. Such a polishing composition can maintain good surface quality of an object to be polished after polishing. Therefore, according to the present aspect, a polishing composition that can improve the surface quality of an object to be polished after polishing can be provided. The present inventors speculate the mechanism as follows, by which the polishing composition according to the present aspect provides such effects. However, the mechanism below is merely speculation and does not limit the scope of the present invention.

In the polishing composition, Compound α has a polyethylene oxide structure and a polypropylene oxide structure, and is thereby adsorbed to the surface of an object to be polished during polishing, so as to be able to suppress mechanical polishing and chemical polishing of the surface of the object to be polished. It is also known that in the polishing composition, the water soluble polymer can act as a buffer for abrasives during polishing. Therefore, the water soluble polymer is adsorbed to the surface of an object to be polished during polishing, can suppress mechanical polishing on the surface of the object to be polished, can reduce unevenness of the object to be polished, and has an effect of suppressing the adhesion of particles onto the surface of the object to be polished after polishing. It has been found that the polishing composition according to the present aspect significantly improves the quality of the surface of an object to be polished by containing Compound α and the water soluble polymer having these effects in a specific mass ratio relative to the abrasive. That is, the polishing composition according to the present aspect can reduce defects on the surface of an object to be polished while maintaining a good polishing removal rate or improving the polishing removal rate.

### [(A) Abrasive]

The polishing composition according to the present aspect contains abrasive. The abrasive has the action of mechanically polishing an object to be polished, improving the polishing removal rate for an object to be polished by the use of the polishing composition. The abrasive contained in the polishing composition according to the present aspect are not particularly limited, and examples thereof include inorganic particles, organic particles, and organic-inorganic composite particles. Among these, inorganic particles are preferred. In the polishing composition according to one preferred embodiment of the present aspect, the abrasive include inorganic particles. Examples of the inorganic particles include, but are not particularly limited to: oxide particles such as silica particles, alumina particles, cerium oxide particles, chromium oxide particles, titanium dioxide particles, zirconium oxide particles, magnesium oxide particles, manganese dioxide particles, zinc oxide particles, and red iron oxide particles; nitride particles such as silicon nitride particles and boron nitride particles; carbide particles such as silicon carbide particles and boron carbide particles; diamond particles; and carbonates such as calcium carbonate and barium carbonate. Among these, silica particles are more preferable, colloidal silica and fumed silica are further preferable, and colloidal silica is particularly preferable.

Examples of a method for producing colloidal silica include a sodium silicate method and a sol-gel method. Colloidal silica produced by either method can be suitably used as the colloidal silica according to the present aspect. However, from the viewpoint of reducing metal impurities, colloidal silica produced by the sol-gel method is preferred. Colloidal silica produced by the sol-gel method is preferred because it contains a small amount of metal impurities that tend to diffuse in semiconductors and corrosive ions such as chloride ions. Colloidal silica can be produced by the sol-gel method using a conventionally known technique. Specifically, colloidal silica can be obtained by using a hydrolyzable silicon compound (e.g., alkoxysilane or a derivative thereof) as a raw material and carrying out a hydrolysis/condensation reaction. Moreover, commercially available colloidal silica may be used.

The shape of the abrasive is not particularly limited, and may be spherical or non-spherical. Specific examples of non-spherical shapes include, but are not particularly limited to, various shapes such as a polygonal prism e.g., a triangular prism or a square prism, a cylinder, a bale shape in which the center of a cylinder bulges more than the ends, a doughnut shape such that the center of a disk is penetrated to form a hole in the middle, a plate shape, a so-called cocoon shape having a constriction in the center, a so-called associated spherical shape in which multiple particles are integrated, a so-called confetti shape having multiple protrusions on the surface, and a rugby ball shape.

Although not particularly limited, the average major axis/minor axis ratio (average aspect ratio) of the abrasive is in principle 1.0 or more, preferably 1.05 or more, and more preferably 1.1 or more. By increasing the average aspect ratio, a higher polishing removal rate can be achieved. Moreover, from the viewpoint of reducing scratches, etc., the average aspect ratio of the abrasive is preferably 3.0 or less, more preferably 2.0 or less, and even more preferably 1.5 or less.

The shape (outer shape) and average aspect ratio of the abrasive can be determined, for example, by observation using an electron microscope. A specific procedure for determining the average aspect ratio is, for example, to use a scanning electron microscope (SEM) to draw the smallest rectangle circumscribing each particle image for a predetermined number (e.g., 200) of silica particles whose individual particle shapes can be recognized. Then, for the rectangle drawn for each particle image, the length of its long side (value of the major axis) is divided by the length of its short side (value of the minor axis) to calculate the major axis/minor axis ratio (aspect ratio). The average aspect ratio can be found by arithmetically averaging the aspect ratios of the predetermined number of particles.

The abrasive contained in the polishing composition may be in the form of primary particles or secondary particles formed by association of a plurality of primary particles. Furthermore, abrasive in the form of primary particles and abrasive in the form of secondary particles may be mixed. In one preferred aspect, at least a portion(s) of the abrasive is contained in the polishing composition in the form of secondary particles.

Here, the surface of an object to be polished (especially silicon wafer) is generally finished to a high-quality mirror surface through a lapping step and a polishing step. The polishing step is usually composed of a plurality of polishing steps including a stock polishing step (stock polishing step, a polishing step prior to a final polishing step) and the final polishing step (final polishing step). For example, a polishing composition with high processing power (abrasive power) tends to be used in the stage of roughly polishing an object to be polished (especially a silicon wafer) (e.g., the stock polishing step), while a polishing composition with low abrasive power tends to be used in the stage of more delicate polishing (e.g., the final polishing step). Thus, each polishing composition to be used herein has polishing properties that are required to be different for each polishing step, and thus the particle size and the content of silica contained in each polishing composition to be used herein can vary depending on the stage of the polishing step in which the polishing composition is used.

The increase in the particle size of abrasive tends to make it easier to mechanically polish the surface of an object to be polished, thereby improving the polishing removal rate. On the other hand, a decrease in the particle size of abrasive tends to make it easier to improve the surface quality of an object to be polished after polishing.

The average primary particle size of the abrasive contained in the polishing composition according to some embodiments of the present invention is not particularly limited, but is preferably 5 nm or more, more preferably 10 nm or more, even more preferably 15 nm or more, and particularly preferably 20 nm or more (e.g., more than 20 nm). The average primary particle size of the abrasive contained in the polishing composition according to some embodiments of the present invention is, for example, 100 nm or less, may be 80 nm or less, is preferably 60 nm or less, more preferably 50 nm or less, further preferably 45 nm or less, and particularly preferably 43 nm or less. In some aspects, the average primary particle size of the abrasive may be less than 42 nm, less than 41 nm, less than 38 nm, less than 36 nm, less than 35 nm, less than 33 nm, or less than 30 nm.

The average secondary particle size of the abrasive contained in the polishing composition according to some embodiments of the present invention is preferably 10 nm or more, more preferably 20 nm or more, further preferably 30 nm or more, and particularly preferably 35 nm or more. In some aspects, the average secondary particle size of the abrasive may be 40 nm or more, 42 nm or more, or 44 nm or more. In addition, the average secondary particle size of the abrasive contained in the polishing composition according to some embodiments of the present invention is, for example, 250 nm or less, may be 180 nm or less, or may be 150 nm or less, is preferably 100 nm or less, more preferably 90 nm or less, and even more preferably 80 nm or less. In some aspects, the average secondary particle size of the abrasive may be 70 nm or less, 60 nm or less, or 50 nm or less.

The preferred ranges of the average primary particle size and the average secondary particle size of the abrasive described above are also the preferred ranges of the average primary particle size and the average secondary particle size of the abrasive contained in a raw material dispersion liquid used in the preparation thereof.

As used herein, the average primary particle size refers to a particle size (BET particle size) calculated from the specific surface area (BET value) measured by the BET method according to the formula: average primary particle size (nm) = 6000/(true density (g/cm³) × BET value (m²/g)). The specific surface area can be measured, for example, by using "Flow SorbII 2300" manufactured by Micromeritics Instrument Corporation. The average secondary particle size of the abrasive can be measured, for example, by a dynamic light scattering method, for example, using "Nanotrac (registered trademark) UPA-UT151" manufactured by Nikkiso Co., Ltd.

As described above, the polishing composition to be used has different polishing properties required for each polishing step, and therefore the content of abrasive in a polishing composition, which is to be employed, may vary depending on the stage of the polishing step in which the polishing composition is used.

At this time, an increase in the content of abrasive tends to improve the polishing removal rate for the surface of an object to be polished. On the other hand, a decrease in the content of abrasive tends to improve the dispersion stability of the polishing composition, and, to reduce the amount of abrasive residues on the polished surface.

When the polishing composition according to some embodiments of the present invention is in the form of a concentrated liquid that is diluted with a dispersion medium or the like for use in polishing, the content of abrasive in the concentrated liquid is not particularly limited, but is preferably 0.001 mass% or more, more preferably 0.01 mass% or more, even more preferably 0.025 mass% or more, even more preferably 0.1 mass% or more, particularly preferably 0.5 mass% or more, even more particularly preferably 1 mass% or more, and most preferably 3 mass% or more. In this case, the content of abrasive in a concentrated liquid of the polishing composition is not particularly limited, but from the viewpoints of storage stability, filterability, and the like, it is preferably 50 mass% or less, more preferably 20 mass% or less, even more preferably 10 mass% or less, and particularly preferably 9 mass% or less.

In addition, when the polishing composition according to some embodiments of the present invention is in the form of a dilute solution, the content of abrasive in the polishing composition is not particularly limited, but from the viewpoint of further improving the polishing removal rate, it is preferably 0.001 mass% or more, more preferably 0.01 mass% or more, even more preferably 0.025 mass% or more, and particularly preferably 0.1 mass% or more. In this case, the content of abrasive in the polishing composition is not particularly limited, but is, for example, less than 10 mass%, may be less than 7 mass%, may be 5 mass% or less, may be 2 mass% or less, is preferably less than 1 mass%, is more preferably 0.8 mass% or less, is even more preferably 0.6 mass% or less, is particularly preferably 0.4 mass% or less, and is most preferably 0.3 mass% or less.

When the content of abrasive is within the above range, Compound α and the water soluble polymer act more effectively on the surface of an object to be polished, thereby making it possible to further reduce defects on the surface of the object to be polished. When the polishing composition contains two or more kinds of abrasives, the content of the abrasive refers to the total amount of these.

When the polishing composition is used as a dilute solution, the content of preferred abrasive is preferably adjusted by diluting the concentrated liquid of the polishing composition with a dispersion medium such as water, or a solution, dispersion or the like containing an arbitrary polishing aid therein.

The polishing composition according to some embodiments of the present invention may also contain silica and other abrasive other than silica. However, when the polishing composition according to some embodiments of the present invention is in the form of a dilute solution, the content of the other abrasive is preferably 5 mass% or less, more preferably 3 mass% or less, even more preferably 2 mass% or less, and particularly preferably 1 mass% or less, relative to the total mass of silica and other abrasive. The most preferred embodiment is one in which the content of other abrasive is 0 mass%, that is, one in which other abrasive other than silica are not contained.

### [(B) Compound α]

The polishing composition according to the present aspect contains Compound α having a polyethylene oxide structure and a polypropylene oxide structure in its molecule. The polyethylene oxide structure is represented by "-(CH₂CH₂-O)ₙ-" (n represents the number of moles added and is an integer of 2 or more), and has a group derived from ethylene oxide (oxyethylene group) (-CH₂CH₂-O-) as a repeating unit. The polypropylene oxide structure is represented by "-(CH(CH₃)CH₂-O)ₘ-" (m represents the number of moles added and is an integer of 2 or more), and has a group derived from propylene oxide (oxypropylene group) (-CH(CH₃)CH₂-O-) as a repeating unit. Hereinafter, a group derived from ethylene oxide (oxyethylene group) may be referred to as "EO", and a group derived from propylene oxide (oxypropylene group) may be referred to as "PO". That is, since "-(CH₂CH₂-O)ₙ-" represents the polyethylene oxide structure, and thus is expressed as "-(EO)ₙ-" or simply "PEO", and since "-(CH(CH₃)CH₂-O)ₘ-" represents the polypropylene oxide structure, and thus is expressed as "-(PO)ₘ-" or simply "PPO".

Compound α may have, as a repeating unit, a group derived from ethylene oxide (EO) and a group derived from propylene oxide (PO), and examples thereof include a block copolymer of EO and PO, a random copolymer of EO and PO, and ethylenediaminetetrapolyoxyethylenepolyoxypropylene (poloxamine). The block copolymer of EO and PO can be a diblock copolymer, a triblock copolymer, etc., containing a polyethylene oxide (PEO) block and a polypropylene oxide (PPO) block. The triblock copolymers include a PEO-PPO-PEO triblock copolymer and a PPO-PEO-PPO triblock copolymer. In the present aspect, the PEO-PPO-PEO triblock copolymer is more preferred from the viewpoint of reducing defects on the surface of an object to be polished.

In the polishing composition according to the present aspect, the molar ratio EO:PO of EO and PO constituting Compound α ranges from preferably 50:50 to 98:2, more preferably 60:40 to 95:15, and even more preferably 70:30 to 90:10.

In the polishing composition according to the present aspect, as a preferred embodiment, Compound α is the PEO-PPO-PEO triblock copolymer. In one embodiment, Compound α is represented by the following structure (1):
[Formula 1]

HO-(R¹O)ₐ-(R²O)_{b}-(R¹O)_{c}-H ··· (1)

[In formula (1), R¹O represents an oxyethylene (-CH₂CH₂-O-) group, R²O represents an oxypropylene (-CH(CH₃)CH₂-O-) group, a and c represent the number of moles of R¹O and are each independently an integer of 1 or more and 999 or less, satisfying (a+c)=2 to 1000, and "b" represents the number of moles of R²O and is an integer of 2 or more and 1,000 or less, and here the molar ratio of R¹O and R²O, (a+c):b, ranges from 70:30 to 90:10.]

Compound α has a weight average molecular weight (Mw) of preferably 100 or more and 10,000 or less, more preferably 150 or more and 8,000 or less, even more preferably 200 or more and 5,000 or less, particularly preferably 250 or more and 4,500 or less, and most preferably 300 or more and 4,000 or less. In one embodiment, the weight average molecular weight of Compound α is 3,500 or less. When the weight average molecular weight of Compound α is within the above range, Compound α and the water soluble polymer act more effectively on the surface of an object to be polished, thereby making it possible to further reduce defects on the surface of the object to be polished. Here, as the weight average molecular weight of Compound α, a molecular weight calculated from a value based on aqueous gel permeation chromatography (GPC) (aqueous, polyethylene oxide equivalent) can be employed. As the GPC measuring device, a model name "HLC-8320GPC" manufactured by Tosoh Corporation may be used. Measurement can be performed, for example, under the following measurement condition 1. The similar method will be employed for the examples described below. If the molecular weight cannot be measured by GPC, the molecular weight calculated from the molecular formula can be employed as the weight average molecular weight.

### [GPC measurement condition 1]

Sample concentration: 0.1 mass%
Column: TSKgel GMPWXL
Detector: differential refractometer
Eluent: 100 mM sodium nitrate aqueous solution/acetonitrile = 10/0 to 8/2 (volume ratio)
Flow rate: 1 mL/min
Measurement temperature: 40°C
Sample injection volume: 100 µL

In the polishing composition according to the present aspect, Compound α may be used alone or in combination of two or more thereof. Moreover, Compound α that may be used herein is a commercially available product or a synthetic product.

The content (concentration) of Compound α in the polishing composition is 0.0001 mass% or more relative to the total mass of the polishing composition. If the content (concentration) of Compound α is less than 0.0001 mass%, Compound α may not act sufficiently on the surface of an object to be polished, and the number of defects on the surface of the object to be polished cannot be reduced. The content (concentration) of Compound α is preferably 0.0002 mass% or more, more preferably 0.0003 mass% or more, even more preferably 0.0005 mass% or more, particularly preferably 0.0008 mass% or more, and most preferably 0.001 mass% or more, relative to the total mass of the polishing composition. In addition, the upper limit of the content (concentration) of Compound α in the polishing composition is preferably 5 mass% or less, more preferably 1 mass% or less, even more preferably 0.5 mass% or less, particularly preferably 0.2 mass% or less, and most preferably 0.1 mass% or less, relative to the total mass of the polishing composition. That is, the content (concentration) of Compound α is preferably 0.0002 mass% or more and 5 mass% or less, more preferably 0.0003 mass% or more and 1 mass% or less, even more preferably 0.0005 mass% or more and 0.5 mass% or less, particularly preferably 0.0008 mass% or more and 0.2 mass% or less, and most preferably 0.001 mass% or more and 0.1 mass% or less, relative to the total mass of the polishing composition. The content (concentration) of Compound α in the polishing composition may be 0.001 mass% or more and 0.01 mass% or less, or may be 0.001 mass% or more and 0.005 mass% or less. The content (concentration) of Compound α in the polishing composition may be 0.001 mass% or more and less than 0.005 mass%, may be 0.001 mass% or more and 0.004 mass% or less, or may be 0.001 mass% or more and 0.003 mass% or less.

In addition, when the polishing composition according to some embodiments of the present invention is in the form of a concentrated liquid that is diluted with a dispersion medium or the like for use in polishing, the content (concentration) of Compound α in the concentrated liquid may be 0.001 mass% or more and 10 mass% or less, 0.005 mass% or more and 1 mass% or less, 0.008 mass% or more and 0.25 mass% or less, or 0.01 mass% or more and 0.1 mass% or less.

When the content (concentration) of Compound α is within this range, Compound α and the water soluble polymer act more effectively on the surface of an object to be polished, so as to be able to further reduce defects on the surface of the object to be polished. When a polishing composition contains two or more kinds of Compound α, the content (concentration) of the two or more kinds of Compound α refers to the total amount thereof.

Here, in the polishing composition of the present aspect, Compound α is contained in such a manner that the ratio of the mass (total mass) of Compound α together with the water soluble polymer described below to the mass of the abrasive is a specific ratio. Specifically, in the polishing composition of the present aspect, the ratio of the total mass of (B) Compound α and (C) the water soluble polymer to the mass of (A) the abrasive, [{(B)+(C)}/(A)], is 0.058 or more and less than 0.150. Hereinafter, the "ratio of the total mass of (B) Compound α and (C) the water soluble polymer to the mass of (A) the abrasive" may be referred to as the "mass ratio of Compound α and the water soluble polymer to the abrasive". When the mass ratio of Compound α and the water soluble polymer to the abrasive is less than 0.058, Compound α and the water soluble polymer may not sufficiently cover the entire surface of an object to be polished, the action of Compound α and the water soluble polymer on the surface of an object to be polished is not fully exhibited, and the number of defects on the surface of the object to be polished cannot be reduced. When the mass ratio of Compound α and the water soluble polymer to the abrasive is 0.150 or more, the amount of Compound α and the water soluble polymer adsorbed to the surface of the object to be polished increases, and the polishing removal rate for the object to be polished decreases.

The mass ratio of Compound α and the water soluble polymer to the abrasive is preferably 0.059 or more, more preferably 0.060 or more, even more preferably 0.062 or more, particularly preferably 0.065 or more, and most preferably 0.068 or more. The mass ratio of Compound α and the water soluble polymer to the abrasive is preferably 0.140 or less, more preferably 0.120 or less, even more preferably 0.100 or less, particularly preferably 0.095 or less, and most preferably 0.090 or less. With the mass ratio of Compound α and the water soluble polymer to the abrasive within the above range, defects on the surface of an object to be polished can be further reduced.

### [(C) Water soluble polymer]

The polishing composition according to the present aspect contains a water soluble polymer different from Compound α. Here, Compound α excluded from the water soluble polymer has an EO structure and a PO structure. Therefore, the water soluble polymers include a water soluble polymer having only either an EO structure or a PO structure.

As used herein, "water soluble" means that the solubility in water (25°C) is 1 g/100 mL or more, and "polymer" refers to a (co)polymer having a weight average molecular weight of 0.5 x 10⁴ or more.

The water soluble polymer may be any water soluble polymer other than Compound α having an EO structure and a PO structure, and the one having at least one functional group selected from the group consisting of a cationic group, an anionic group, or a nonionic group in the molecule can be used. Examples thereof include a water soluble polymer having an anionic group, a water soluble polymer having a cationic group, and a water soluble polymer having a nonionic group. As used herein, the "anionic group" refers to a functional group that becomes an anion through dissociation of counter ions. The "cationic group" refers to a functional group that becomes a cation through dissociation of counter ions or binding with a cationic species generated by electrolytic dissociation of another ionic compound(s). The "nonionic group" refers to a functional group that does not ionize.

Examples of the cationic groups include, but are not particularly limited to, an amino group or a group of a salt thereof. Examples of a water soluble polymer having a cationic group include cationized cellulose, cationized guar gum, polydimethyldimethylenepyrrolidinium chloride, dimethyldimethylenepyrrolidinium chloride-(meth)acrylamide copolymer, (meth)acrylamide·(meth)acrylic acid·dimethyldiallylammonium chloride copolymer, a polymer of N,N-dimethylaminoethyl diethyl(meth)acrylate sulfate, and N,N-dimethyl polyethylene glycol(meth)acrylate.

Examples of an anionic group include a carboxy group, a sulfo group, a phosphonic acid group, or groups of salts thereof.

Examples of the water soluble polymer having a carboxy group or a group of a salt thereof (carboxy group-containing water soluble polymer) include poly(meth)acrylic acid and derivatives thereof, and salts thereof.

Examples of the polymer (sulfo group-containing water soluble polymer) having a sulfo group or a group of a salt thereof include sulfonic acid modified polyvinyl alcohols (sulfonic acid group-containing polyvinyl alcohol, sulfonic acid group-containing modified polyvinyl alcohol), sulfonic acid group-containing polystyrenes such as polystyrene sulfonic acid (sulfonic acid group-containing modified polystyrene), sulfonic acid modified polyvinyl acetates (sulfonic acid group-containing polyvinyl acetate, sulfonic acid group-containing modified polyvinyl acetate), sulfonic acid group-containing polyesters (sulfonic acid group-containing modified polyester), copolymers of (meth)acrylic acid-containing monomers-sulfonic acid group-containing monomers, such as copolymers of (meth)acrylic acid-sulfonic acid group-containing monomers, and derivatives thereof, as well as salts of these.

Examples of the polymer having a phosphonic acid group (-P(=O)(OH)₂) or a group of a salt thereof (phosphonic acid group-containing water soluble polymer) include (co)polymers containing structural units constituted from monomers such as 2-hydroxyethyl(meth)acryloylphosphate, phenyl-2-acryloyloxyethylphosphate, and derivatives thereof, as well as salts thereof. Further examples thereof include (co)polymers containing structural units constituted from monomers such as (meth)acryloyloxymethyl phosphate, (meth)acryloyloxyethyl phosphate, (meth)acryloyloxypropyl phosphate, (meth)acryloyloxybutyl phosphate, (meth)acryloyloxypentyl phosphate, (meth)acryloyloxyhexyl phosphate, (meth)acryloyloxyoctyl phosphate, (meth)acryloyloxydecyl phosphate, (meth)acryloyloxylauryl phosphate, (meth)acryloyloxystearyl phosphate, and (meth)acryloyloxy-1,4-dimethylcyclohexyl phosphate, as well as derivatives thereof and salts thereof. Here, the "(co)polymer" refers to a copolymer or a homopolymer. Examples of monomers constituting the structural units of the (co)polymer other than the above-mentioned structural units include: aromatic vinyl compounds such as styrene, α-methylstyrene, vinyltoluene, 2,4-dimethylstyrene, ethylstyrene, phenylstyrene, cyclohexylstyrene, and benzylstyrene; hydroxy group-containing vinyl monomers such as hydroxystyrene, N-methylol(meth)acrylamide, hydroxyethyl(meth)acrylate, hydroxypropyl(meth)acrylate, polyethylene glycol mono(meth)acrylate, and 2-hydroxyethylpropenyl ether; and alkyl(meth)acrylates such as methyl(meth)acrylate, ethyl(meth)acrylate, propyl(meth)acrylate, butyl(meth)acrylate, 2-ethylhexyl(meth)acrylate, dodecyl(meth)acrylate, hexadecyl(meth)acrylate, and eicosyl(meth)acrylate. As used herein, "having a phosphonic acid group or a group(s) of a salt(s) thereof" means that the compound has a partial structure represented as a phosphonic acid group (-P(=O)(OH)₂) or a salt thereof, and examples thereof include a case where the phosphonic acid group or a group of a salt thereof exists in the form of a phosphate group (-OP(=O)(OH)₂) or a salt thereof.

Examples of the water soluble polymer having a nonionic group include compounds containing a hydroxyl group, an acyloxy group, a vinyl structure, a polyoxyalkylene structure, a heterocyclic structure, an amide structure, an imide structure, or the like in the molecule. Examples of the water soluble polymer having a nonionic group include vinyl alcohol-based polymers, polymers containing oxyalkylene units (excluding Compound α having an EO structure and a PO structure), cellulose derivatives, starch derivatives, and nitrogen atom-containing polymers.

The "vinyl alcohol-based polymer" refers to a polymer having a vinyl alcohol unit (a structural portion represented by -CH₂-CH(OH)-; hereinafter, also referred to as a "VA unit") in one molecule. The vinyl alcohol-based polymer may also be a copolymer containing, in addition to the VA unit, a non-vinyl alcohol unit (a structural unit derived from a monomer other than vinyl alcohol, hereinafter also referred to as a "non-VA unit"). The non-VA unit has at least one structure selected from an oxyalkylene group, a carboxy group, a (di)carboxylic acid group, a (di)carboxylic acid ester group, a phenyl group, a naphthyl group, a sulfo group, an amino group, a hydroxyl group, an amide group, an imide group, a nitrile group, an ether group, an ester group, or salts thereof. Examples of the non-VA unit may include, but are not particularly limited to, a repeating unit derived from a N-vinyl type monomer or a N-(meth)acryloyl type monomer, a repeating unit derived from ethylene, a repeating unit derived from an alkyl vinyl ether, and a repeating unit derived from a vinyl ester of monocarboxylic acid having 3 or more carbon atoms. A suitable example of the N-vinyl type monomer is N-vinylpyrrolidone. A suitable example of the N-(meth)acryloyl type monomer is N-(meth)acryloylmorpholine. The alkyl vinyl ether can be, for example, a vinyl ether having an alkyl group having 1 or more and 10 or less carbon atoms, such as propyl vinyl ether, butyl vinyl ether, or 2-ethylhexyl vinyl ether. The vinyl ester of monocarboxylic acid having 3 or more carbon atoms can be, for example, a vinyl ester of monocarboxylic acid having 3 or more and 7 or less carbon atoms, such as vinyl propanoate, vinyl butanoate, vinyl pentanoate, or vinyl hexanoate. Suitable examples of the (di)acetone compound include diacetone (meth)acrylamide and acetylacetone. When the vinyl alcohol-based polymer contains the non-VA unit, it may contain only one kind of non-VA unit, or may contain two or more kinds of non-VA unit. The content ratio (molar ratio) of the VA unit to the non-VA unit is not particularly limited, and for example, the VA unit : non-VA unit (molar ratio) ranges from preferably 1:99 to 99:1, and more preferably 95:5 to 50:50. Examples of the vinyl alcohol-based polymer include polyvinyl alcohol (PVA), vinyl alcohol-ethylene copolymer, and acetalized polyvinyl alcohol. Acetalized polyvinyl alcohol is a vinyl alcohol-based polymer in which a portion of VA units contained in the polyvinyl alcohol is acetalized with aldehyde.

The degree of saponification of polyvinyl alcohol is not particularly limited, but is preferably 80% or more and 100% or less, more preferably 90% or more and 100% or less, even more preferably 95% or more and 100% or less, and particularly preferably 98% or more and 100% or less.

The polymer having an oxyalkylene unit refers to a polymer containing a (poly)oxyalkylene group (excluding Compound α having an EO structure and a PO structure). Here, the (poly)oxyalkylene group represents an oxyalkylene group or a polyoxyalkylene group. Examples of the polymer having an oxyalkylene unit include: polyalkylene oxides such as polyethylene oxide (PEO) and polypropylene oxide (PPO); various polyalkylene glycol alkyl ethers such as polyethylene glycol oleyl ether and polyethylene glycol dimethyl ether; and polyalkylene glycol alkyl esters such as polyethylene glycol monooctyl ester, polypropylene glycol monostearyl ester, and polypropylene glycol distearyl ester.

The cellulose derivative refers to a cellulose derivative in which a portion(s) of the hydroxyl groups of cellulose is substituted with other different substituents. Examples of the cellulose derivative include hydroxyethyl cellulose (HEC), hydroxypropyl cellulose, hydroxyethyl methyl cellulose, hydroxypropyl methyl cellulose, methyl cellulose, ethyl cellulose, ethyl hydroxyethyl cellulose, and carboxymethyl cellulose.

The starch derivative refers to starch or a starch derivative in which a portion(s) of the hydroxyl groups of starch is substituted with other different substituents. An example of the starch derivative is pullulan.

Examples of the nitrogen atom-containing polymer include: polymers containing N-vinyl type monomer units; and polymers containing N-(meth)acryloyl type monomer units. Examples of N-vinyl type polymers include polymers containing a repeating unit derived from a monomer having a nitrogen-containing heterocycle (e.g., a lactam ring). Examples of such polymers include homopolymers and copolymers of N-vinyl lactam type monomers (e.g., copolymers in which the copolymerization ratio of N-vinyl lactam type monomers exceeds 50 mass%), and homopolymers and copolymers of N-vinyl chain amides (e.g., copolymers in which the copolymerization ratio of N-vinyl chain amides exceeds 50 mass%). Specific examples of N-vinyl lactam type monomers (i.e., compounds having a lactam structure and a N-vinyl group in one molecule) include N-vinyl pyrrolidone (VP), N-vinyl piperidone, N-vinyl morpholinone, N-vinyl caprolactam (VC), N-vinyl-1,3-oxazin-2-one, and N-vinyl-3,5-morpholinedione. Specific examples of polymers containing N-vinyl lactam type monomer units include polyvinylpyrrolidone, polyvinylcaprolactam, random copolymers of VP and VC, random copolymers of one or both of VP and VC with other vinyl monomers (e.g., acrylic monomers and vinyl ester monomers), block copolymers containing polymer chains containing one or both of VP and VC, alternating copolymers, and graft copolymers. Specific examples of N-vinyl chain amides include N-vinylacetamide, N-vinylpropionic acid amide, and N-vinylbutyric acid amide.

Examples of N-(meth)acryloyl type polymers include homopolymers and copolymers of N-(meth)acryloyl type monomers (typically copolymers in which the copolymerization ratio of N-(meth)acryloyl type monomers exceeds 50 mass%). Examples of N-(meth)acryloyl type monomers include chain amides having N-(meth)acryloyl groups and cyclic amides having N-(meth)acryloyl groups. Examples of the chain amides having N-(meth)acryloyl groups include: (meth)acrylamide; N-alkyl (meth)acrylamides such as N-methyl (meth)acrylamide, N-ethyl (meth)acrylamide, N-propyl (meth)acrylamide, N-isopropyl (meth)acrylamide, and N-n-butyl (meth)acrylamide; and N,N-dialkyl (meth)acrylamides such as N,N-dimethyl (meth)acrylamide, N,N-diethyl (meth)acrylamide, N,N-dipropyl (meth)acrylamide, N,N-diisopropyl (meth)acrylamide, and N,N-di(n-butyl) (meth)acrylamide. Examples of polymers containing a chain amide having a N-(meth)acryloyl group as a monomer unit include homopolymers of N-isopropylacrylamide and copolymers of N-isopropylacrylamide (for example, copolymers in which the copolymerization ratio of N-isopropylacrylamide exceeds 50 mass%).

Examples of cyclic amides having N-(meth)acryloyl groups include N-acryloylmorpholine, N-acryloylthiomorpholine, N-acryloylpiperidine, N-acryloylpyrrolidine, N-methacryloylmorpholine, N-methacryloylpiperidine, and N-methacryloylpyrrolidine. An example of a polymer containing a cyclic amide having a N-(meth)acryloyl group as a monomer unit is an acryloylmorpholine-based polymer (PACMO). Typical examples of the acryloylmorpholine-based polymer include homopolymers of N-acryloylmorpholine (ACMO) and copolymers of ACMO (for example, copolymers in which the copolymerization ratio of ACMO exceeds 50 mass%). In an acryloylmorpholine-based polymer, the proportion of the number of moles of ACMO units in the number of moles of all repeating units is usually 50% or more, and appropriately 80% or more (e.g., 90% or more, typically 95% or more). All repeating units of the water soluble polymer may be substantially composed of ACMO units.

When the water soluble polymer is in the form of a salt, examples of the salt include, but are not particularly limited to, alkali metal salts such as a sodium salt and a potassium salt, salts of Group 2 elements such as a calcium salt and a magnesium salt, an amine salt, and an ammonium salt.

The weight average molecular weight Mw of the water soluble polymer may be, for example, about 200×10⁴ or less, and is appropriately about 150×10⁴ or less, and from the viewpoint of cleaning properties, etc., is preferably about 100×10⁴ or less, and may be about 50×10⁴ or less. In addition, from the viewpoint of protecting the polishing surface, the Mw of the water soluble polymer is preferably, for example, 0.5×10⁴ or more. In some aspects, the Mw is appropriately 1.0×10⁴ or more, and may be 1.5×10⁴ or more, 2×10⁴ or more, for example, 5×10⁴ or more.

The preferred molecular weight range of the water soluble polymer compound can vary depending on the kind of polymer used. For example, the Mw of a polyvinyl alcohol-based polymer can be 100×10⁴ or less, and is appropriately 60×10⁴ or less. From the viewpoint of concentration efficiency, and the like, the Mw may be 30×10⁴ or less, preferably 20×10⁴ or less, for example, may be 10×10⁴ or less, 8×10⁴ or less, 5×10⁴ or less, 3×10⁴ or less, 2×10⁴ or less, or 1.5×10⁴ or less. As the Mw of the polyvinyl alcohol-based polymer is decreased, the dispersion stability of the polyvinyl alcohol-based polymer tends to be improved. In addition, from the viewpoint of suitably protecting the polished surface and maintaining or improving the surface quality, the Mw is preferably, for example, 0.5×10⁴ or more. In some aspects, the Mw is appropriately 0.8×10⁴ or more, and may be 1.0×10⁴ or more.

For example, the Mw of the polymer containing an oxyalkylene unit can be 10×10⁴ or less, and may be 5×10⁴ or less, 3×10⁴ or less, or 2×10⁴ or less. The Mw can be 0.5×10⁴ or more, and may be 1×10⁴ or more, 1.2×10⁴ or more, or 1.5×10⁴ or more.

For example, the Mw of the cellulose derivative and the Mw of the starch derivative can each be about 500×10⁴ or less, and is each appropriately 300×10⁴ or less. The Mw may be about 200×10⁴ or less, or may be about 100×10⁴ or less (for example, about 80×10⁴ or less). From the viewpoint of protecting the polished surface, the Mw is appropriately, for example, about 5.0×10⁴ or more, preferably about 10×10⁴ or more, more preferably about 30×10⁴ or more, even more preferably about 35×10⁴ or more, may be about 40×10⁴ or more, or may be about 50×10⁴ or more. It may be about 55×10⁴ or more.

For example, the Mw of the nitrogen atom-containing polymer having a cyclic structure (suitably PACMO) can be 100×10⁴ or less, and is appropriately 70×10⁴ or less. From the viewpoint of concentration efficiency, and the like, the Mw may be 60×10⁴ or less, or may be 50×10⁴ or less. From the viewpoint of maintaining or improving surface quality, the Mw may be, for example, 1.0×10⁴ or more, or may be 10×10⁴ or more. In some aspects, the Mw may be appropriately 20×10⁴ or more, and may preferably be 30×10⁴ or more.

As the Mw of the cellulose derivative and the Mw of the starch derivative, the molecular weights that are calculated from values based on aqueous gel permeation chromatography (GPC) (aqueous, pullulan equivalent) can be employed. As a GPC measuring device, a model called "HLC-8320GPC" manufactured by Tosoh Corporation may be used. Measurement can be performed, for example, under the following measurement condition 2. The same method is employed in the examples described later.

### [GPC measurement condition 2]

Sample concentration: 0.1 mass%
Column: Asahipak GF-7MHQ, Asahipak GF-310HQ (7.5 mm I.D.×300 mm×2)
Detector: differential refractometer
Eluent: 0.7 mass% sodium chloride aqueous solution
Flow rate: 1 mL/min
Measurement temperature: 40°C
Sample injection volume: 100 µL.

As the Mw of the water soluble polymer other than the cellulose derivative and the starch derivative, the molecular weight that is calculated from values based on aqueous gel permeation chromatography (GPC) (aqueous, polyethylene oxide equivalent) can be employed. The GPC measurement condition that can be employed is the same as the measurement condition 1 for Compound α described above. The same method is employed in the examples described below.

The water soluble polymer may be used alone or in combination of two or more thereof. In addition, as the water soluble polymer, a commercially available product or a synthetic product may be used.

From the viewpoint of further exhibiting the intended effect of the present aspect, the water soluble polymer is preferably a water soluble polymer having a hydroxyl group, and more preferably hydroxyethyl cellulose. According to one embodiment, examples of the water soluble polymer include hydroxyethyl cellulose and poly N-acryloylmorpholine. According to one embodiment, the water soluble polymers are hydroxyethyl cellulose and PACMO. In this case, the mass ratio of hydroxyethyl cellulose:poly N-acryloylmorpholine (hydroxyethyl cellulose:poly N-acryloylmorpholine) ranges from preferably 70:30 to 99:1, more preferably 80:20 to 99:1, even more preferably 85:15 to 99:1, and particularly preferably 90:10 to 98:2. Therefore, according to one embodiment, the water soluble polymers are hydroxyethyl cellulose and poly N-acryloylmorpholine, and the mass ratio of hydroxyethyl cellulose:poly N-acryloylmorpholine ranges from 70:30 to 99:1 (preferably 80:20 to 99:1, more preferably 85:15 to 99:1, and even more preferably 90:10 to 98:2).

When the polishing composition according to some embodiments of the present aspect is in the form of a concentrated liquid that is prepared by diluting the polishing composition with a dispersion medium or the like for use in polishing, the content (concentration) of the water soluble polymer in the concentrated liquid is not particularly limited, but is preferably 0.001 mass% or more, more preferably 0.005 mass% or more, and even more preferably 0.01 mass% or more. In this case, the content (concentration) of the water soluble polymer in the concentrated liquid of the polishing composition is not particularly limited, but is preferably 15 mass% or less, more preferably 5 mass% or less, and even more preferably 3 mass% or less, from the viewpoint of storage stability, etc. That is, when the polishing composition is in the form of a concentrated liquid, the content (concentration) of the water soluble polymer is preferably 0.001 mass% or more and 15 mass% or less, more preferably 0.005 mass% or more and 5 mass% or less, and even more preferably 0.01 mass% or more and 3 mass% or less.

When the polishing composition according to some embodiments of the present aspect is in the form of a dilute solution, the content (concentration) of the water soluble polymer in the polishing composition is preferably 0.0001 mass% or more, more preferably 0.0003 mass% or more, even more preferably 0.0005 mass% or more, particularly preferably 0.001 mass% or more, and most preferably 0.005 mass% or more, relative to the total mass of the polishing composition. In this case, the upper limit of the content (concentration) of the water soluble polymer in the polishing composition is preferably 5 mass% or less, more preferably 1 mass% or less, even more preferably 0.5 mass% or less, particularly preferably 0.2 mass% or less, and most preferably 0.1 mass% or less, relative to the total mass of the polishing composition. That is, when the polishing composition is in the form of a dilute solution, the content (concentration) of the water soluble polymer is preferably 0.0001 mass% or more and 5 mass% or less, more preferably 0.0003 mass% or more and 1 mass% or less, even more preferably 0.0005 mass% or more and 0.5 mass% or less, particularly preferably 0.001 mass% or more and 0.2 mass% or less, and most preferably 0.005 mass% or more and 0.1 mass% or less, relative to the total mass of the polishing composition. When the polishing composition is in the form of a dilute solution, the content (concentration) of the water soluble polymer in the polishing composition may be 0.001 mass% or more and 0.05 mass% or less, or may be 0.005 mass% or more and 0.05 mass% or less.

### [(D) Basic compound]

The polishing composition according to the present aspect contains a basic compound. The basic compound refers to a compound that has a function of increasing the pH of water when added to water.

Examples of the kind of basic compound include, but are not particularly limited to, organic or inorganic basic compounds containing nitrogen, hydroxides of alkali metals or Group 2 metals, various carbonates and bicarbonates, quaternary ammonium or its salts, ammonia, and amines. Specific examples of alkali metal hydroxides include potassium hydroxide and sodium hydroxide. Examples of Group 2 metal hydroxides include calcium hydroxide, strontium hydroxide, and barium hydroxide. Specific examples of carbonates or bicarbonates include ammonium bicarbonate, ammonium carbonate, potassium bicarbonate, potassium carbonate, sodium bicarbonate, and sodium carbonate. Specific examples of quaternary ammonium or its salts include quaternary ammonium hydroxides such as tetramethylammonium hydroxide (TMAH), tetraethylammonium hydroxide, and tetrabutylammonium hydroxide. Specific examples of amines include methylamine, dimethylamine, trimethylamine, ethylamine, diethylamine, triethylamine, ethylenediamine, monoethanolamine, N-(β-aminoethyl)ethanolamine, hexamethylenediamine, diethylenetriamine, triethylenetetramine, anhydrous piperazine, piperazine hexahydrate, 1-(2-aminoethyl)piperazine, N-methylpiperazine, guanidine, and azoles such as imidazole and triazole.

From the viewpoint of reducing surface defects, the basic compound is preferably at least one selected from the group consisting of ammonia, quaternary ammonium (preferably quaternary ammonium hydroxide), carbonates, hydrogen carbonates, or hydroxides of alkali metals. Among these, at least one selected from the group consisting of ammonia, tetramethylammonium hydroxide, tetraethylammonium hydroxide, potassium hydroxide, or sodium hydroxide is preferred, and at least one selected from the group consisting of ammonia or tetramethylammonium hydroxide is more preferred. The basic compound may be used alone or in combination of two or more thereof.

The basic compound that may be used herein is a commercially available product or a synthetic product.

When the polishing composition according to some embodiments of the present aspect is in the form of a concentrated liquid that is diluted with a dispersion medium or the like for use in polishing, the content (concentration) of the basic compound in the concentrated liquid is not particularly limited, but is preferably 0.001 mass% or more, more preferably 0.005 mass% or more, even more preferably 0.01 mass% or more, and particularly preferably 0.05 mass% or more. In addition, in this case, the content (concentration) of the basic compound in the concentrated liquid of the polishing composition is not particularly limited, but from the viewpoint of storage stability, etc., it is preferably 45 mass% or less, more preferably 15 mass% or less, even more preferably 5 mass% or less, and particularly preferably 1 mass% or less. That is, when the polishing composition is in the form of a concentrated liquid, the content (concentration) of the basic compound is preferably 0.001 mass% or more and 45 mass% or less, more preferably 0.005 mass% or more and 15 mass% or less, even more preferably 0.01 mass% or more and 5 mass% or less, and particularly preferably 0.05 mass% or more and 1 mass% or less.

When the polishing composition according to some embodiments of the present aspect is in the form of a dilute solution, the content (concentration) of the basic compound in the polishing composition is not particularly limited, but from the viewpoint of improving the polishing removal rate, etc., it is preferably 0.0001 mass% or more, more preferably 0.0005 mass% or more, even more preferably 0.001 mass% or more, even more preferably 0.002 mass% or more, and particularly preferably 0.003 mass% or more, relative to the total mass of the polishing composition. In addition, in this case, the content (concentration) of the basic compound in the polishing composition is not particularly limited, but from the viewpoint of improving surface quality, etc., such as reducing defects, it is preferably 15 mass% or less, more preferably 10 mass% or less, even more preferably 5 mass% or less, even more preferably 1 mass% or less, and particularly preferably 0.5 mass% or less, relative to the total mass of the polishing composition. That is, when the polishing composition is in the form of a dilute solution, the content (concentration) of the basic compound in the polishing composition is preferably 0.0001 mass% or more and 15 mass% or less, more preferably 0.0005 mass% or more and 10 mass% or less, even more preferably 0.001 mass% or more and 5 mass% or less, even more preferably 0.002 mass% or more and 1 mass% or less, and particularly preferably 0.003 mass% or more and 0.5 mass% or less.

### [pH]

The pH of the polishing composition according to the present aspect is preferably 7.0 or more, more preferably 7.5 or more, even more preferably 8.0 or more, particularly preferably 8.5 or more, and most preferably 9.0 or more. The pH of the polishing composition is preferably 12.5 or less, more preferably 12.0 or less, even more preferably 11.5 or less, particularly preferably 11.0 or less, and most preferably 10.5 or less. That is, the pH of the polishing composition is preferably 7.0 or more and 12.5 or less, more preferably 7.5 or more and 12.0 or less, even more preferably 8.0 or more and 11.5 or less, particularly preferably 8.5 or more and 11.0 or less, and most preferably 9.0 or more and 10.5 or less. In one embodiment, the pH of the polishing composition is 9.5 or more and 11.0 or less. If the pH of the polishing composition is in such a range, Compound α and the water soluble polymer act more effectively on the surface of an object to be polished, and defects on the surface of the object to be polished can be further reduced.

The content of the pH adjusting agent can be selected by appropriately adjusting it within the range in which the effects of the present aspect are exhibited. The pH of the polishing composition can be measured, for example, with a pH meter (for example, a pH meter (model number: LAQUA) manufactured by Horiba, Ltd.).

### [(E) Dispersion medium]

The polishing composition according to the present aspect contains a dispersion medium for dispersion each component. The dispersion medium (particularly water) has a function of dissolving or dispersion the components contained in the polishing composition.

The dispersion medium may be a mixed solvent of water and an organic solvent for dispersion or dissolving each component. In this case, examples of the organic solvent to be used include acetone, acetonitrile, ethanol, methanol, isopropanol, glycerin, ethylene glycol, propylene glycol, etc., which are organic solvents miscible with water. In addition, these organic solvents may be used without mixing with water to disperse or dissolve each component, and then mixed with water. These organic solvents can be used alone or in combination of two or more thereof. According to a preferred embodiment of the present aspect, the dispersion medium contains water. According to a more preferred embodiment of the present aspect, the dispersion medium is substantially composed of water. Note that the above "substantially" is intended to mean that a dispersion medium other than water can be contained, as long as the effects of the present aspect can be achieved. More specifically, the dispersion medium is preferably composed of 90 mass% or more and 100 mass% or less of water and 0 mass% or more and 10 mass% or less of a dispersion medium other than water, and more preferably composed of 99 mass% or more and 100 mass% or less of water and 0 mass% or more and 1 mass% or less of a dispersion medium other than water. According to the most preferred embodiment of the present aspect, the dispersion medium is composed of only water.

From the viewpoint of preventing contamination of an object to be polished or inhibition of the action of other components, preferably the water contains as few impurities as possible. An example of such water is preferably water with a total transition metal ion content of 100 ppb or less. Here, the purity of water can be increased by, for example, removing impurity ions using ion exchange resin, removing foreign matter using a filter, or operations such as distillation. Specifically, it is preferable to use, for example, deionized water (ion-exchanged water), pure water, ultrapure water, distilled water, etc., as the water.

### [Other components]

The polishing composition according to the present aspect may further contain additives that can be used in the polishing composition, such as a chelating agent (complexing agent), a pH adjusting agent, an antifungal agent (antiseptic agent), and a surfactant (excluding the above-mentioned Compound α), within a range that does not inhibit the effects of the present aspect. The chelating agent, the pH adjusting agent, the antifungal agent (antiseptic agent), and the surfactant will be described below. The oxidizing agent will also be described.

### [Chelating Agent]

The chelating agent captures metal impurity components in the polishing system to form a complex, thereby suppressing metal contamination on the surface of an object to be polished. The polishing composition according to one embodiment of the present aspect may further contain a chelating agent.

Specific examples of the chelating agent include aminocarboxylic acid-based chelating agents and organic phosphonic acid-based chelating agents. Specific examples of the aminocarboxylic acid-based chelating agents include ethylenediaminetetraacetic acid, sodium ethylenediaminetetraacetate, nitrilotriacetic acid, sodium nitrilotriacetate, ammonium nitrilotriacetate, hydroxyethylethylenediaminetriacetic acid, sodium hydroxyethylethylenediaminetriacetate, diethylenetriaminepentaacetic acid, sodium diethylenetriaminepentaacetate, triethylenetetraminehexaacetic acid, and sodium triethylenetetraminehexaacetate. Specific examples of the organic phosphonic acid-based chelating agents include 2-aminoethylphosphonic acid, 1-hydroxyethylidene-1,1-diphosphonic acid, aminotri(methylenephosphonic acid), ethylenediaminetetrakis(methylenephosphonic acid), diethylenetriaminepenta(methylenephosphonic acid), ethane-1,1,-diphosphonic acid, ethane-1,1,2-triphosphonic acid, ethane-1-hydroxy-1,1-diphosphonic acid, ethane-l-hydroxy-l, 1,2-triphosphonic acid, ethane-1,2-dicarboxy-1,2-diphosphonic acid, methanehydroxyphosphonic acid, 2-phosphonobutane-1,2-dicarboxylic acid, 1-phosphonobutane-2,3,4-tricarboxylic acid, and α-methylphosphonosuccinic acid. Among these chelating agents, it is preferable to use an organic phosphonic acid-based chelating agent, in particular ethylenediaminetetrakis(methylenephosphonic acid). The chelating agent may be used alone or in combination of two or more thereof.

### [pH adjusting agent]

In the polishing composition of the present aspect, the pH can be adjusted with the use of each component described above, but the pH can also be adjusted to a desired pH by further using a pH adjusting agent. Therefore, the polishing composition of the present aspect may further contain a pH adjusting agent. Examples of the pH adjusting agent include compounds other than the basic compounds described above, such as inorganic acid and organic acid. These may be used alone or in combination of two or more thereof.

Specific examples of the inorganic acid that can be used as a pH adjusting agent include hydrochloric acid, sulfuric acid, nitric acid, fluoric acid, boric acid, carbonic acid, hypophosphorous acid, phosphorous acid, and phosphoric acid. Of these, hydrochloric acid, sulfuric acid, nitric acid, or phosphoric acid is preferred, and nitric acid is more preferred.

Specific examples of the organic acid that can be used as a pH adjusting agent include formic acid, acetic acid, propionic acid, butyric acid, valeric acid, 2-methylbutyric acid, n-hexanoic acid, 3,3-dimethylbutyric acid, 2-ethylbutyric acid, 4-methylpentanoic acid, n-heptanoic acid, 2-methylhexanoic acid, n-octanoic acid, 2-ethylhexanoic acid, benzoic acid, glycolic acid, salicylic acid, glyceric acid, oxalic acid, malonic acid, succinic acid, glutaric acid, adipic acid, pimelic acid, maleic acid, phthalic acid, malic acid, tartaric acid, citric acid, lactic acid, diglycolic acid, 2-furancarboxylic acid, 2,5-furandicarboxylic acid, 3-furancarboxylic acid, 2-tetrahydrofurancarboxylic acid, methoxyacetic acid, methoxyphenylacetic acid, phenoxyacetic acid, methanesulfonic acid, ethanesulfonic acid, 10-camphorsulfonic acid, and isethionic acid.

As a pH adjusting agent, salts such as alkali metal salts of inorganic acids or organic acids may be used in place of or in combination with inorganic acids or organic acids. In the case of combinations of a weak acid and a strong base, a strong acid and a weak base, or a weak acid and a weak base, a pH buffering effect can be expected.

### [Antifungal agent]

The antifungal agent (antiseptic agent) is not particularly limited and can be appropriately selected depending on the desired applications and purposes. Specific examples thereof include isothiazoline-based antiseptic agents such as 1,2-benzisothiazol-3(2H)-one (BIT), 2-methyl-4-isothiazolin-3-one, and 5-chloro-2-methyl-4-isothiazolin-3-one, and phenoxyethanol.

### [Surfactant]

The surfactant may be used alone or in combination of two or more thereof. Examples of the surfactant include, but are not particularly limited to, anionic surfactants, nonionic surfactants, cationic surfactants, and amphoteric surfactants. The dispersion stability of the polishing composition can be improved by the use of a surfactant (e.g., a water soluble organic compound with a molecular weight of less than 0.5x10⁴). As the Mw of the surfactant that can be employed herein is a value determined by GPC (water-based, polyethylene oxide equivalent) or a value calculated from a chemical formula. The measurement conditions of GPC that can be employed herein are the same as those of the above-mentioned Compound α.

### [Oxidizing agent]

The polishing composition according to some embodiments of the present aspect preferably does not substantially contain an oxidizing agent. If an oxidizing agent is contained in the polishing composition, the surface of an object to be polished (especially a silicon wafer) is oxidized to form an oxide film, which increases the required polishing time. Specific examples of the oxidizing agent mentioned here include hydrogen peroxide (H₂O₂), sodium persulfate, ammonium persulfate, and sodium dichloroisocyanurate. The expression the polishing composition "does not substantially contain an oxidizing agent" means that the oxidizing agent is not contained at least intentionally. Therefore, a polishing composition that inevitably contains a trace quantity of the oxidizing agent (for example, the molar concentration of the oxidizing agent in the polishing composition is 0.001 mol/L or less, preferably 0.0005 mol/L or less, more preferably 0.0001 mol/L or less, even more preferably 0.00005 mol/L or less, and particularly preferably 0.00001 mol/L or less) due to raw materials, manufacturing methods, etc., can be included in the concept of the polishing composition that does not substantially contain an oxidizing agent.

### [Method for producing the polishing composition]

The method for producing the polishing composition according to some embodiments of the present aspect is not particularly limited. For example, the polishing composition can be produced by adding abrasive , Compound α, a water soluble polymer, a basic compound, and other components added as necessary to a dispersion medium all at once or sequentially, and stirring in a dispersion medium.

### [Forms of polishing composition]

The polishing composition according to some embodiments of the present aspect may be a one-liquid type or a multi-liquid type consisting of two or more liquids. The polishing composition described above may be directly used for polishing, or may be prepared by adding water to dilute the concentrated liquid of the polishing composition, or in the case of a multi-agent type polishing composition, diluting it with an aqueous solution containing water and a portion of the constituents, and then used for polishing. For example, the concentrated liquid of the polishing composition can be stored or transported, and then diluted at the time of use to prepare the polishing composition. Thus, according to the present invention, a concentrated liquid of the polishing composition according to the present aspect is also provided (the polishing composition according to the present aspect can be in the form of a concentrated liquid).

The polishing composition in a concentrated form may have an advantage from the viewpoint of convenience and cost reduction etc., during production, distribution, storage, etc. The concentration ratio can be, for example, about 2 or more times and 100 or less times in volume terms, and is usually appropriately about 5 or more times and 50 or less times. The concentration ratio of the polishing composition (concentrated liquid) in a preferred aspect (the concentration ratio when the polishing composition is in the form of a concentrated liquid) is 10 or more times and 40 or less times, for example, 15 or more times and 30 or less times.

### [Object to be polished]

An object to be polished using the polishing composition according to some embodiments of the present invention is not particularly limited, and the polishing composition can be applied to the polishing of objects to be polished having various material types and shapes. Examples of the materials of an object to be polished include: metals or semimetals such as a silicon material, aluminum, nickel, tungsten, steel, tantalum, titanium, and stainless steel, or other, or their alloys; glassy materials such as quartz glass, aluminosilicate glass, and glassy carbon; ceramic materials such as alumina, silica, sapphire, silicon nitride, tantalum nitride, and titanium carbide; compound semiconductor substrate materials such as silicon carbide, gallium nitride, and gallium arsenide; resin materials such as polyimide resin; and the like. In addition, the object to be polished may also be composed of a plurality of the above-mentioned materials.

Among these, silicon materials are preferred because the effects of the polishing composition according to some embodiments of the present invention are more pronounced. The polishing composition according to some embodiments of the present invention is preferably used to polish a substrate having a surface made of a silicon material.

The silicon material preferably contains at least one material selected from the group consisting of silicon single crystal, amorphous silicon, or polysilicon. From the viewpoint of being capable of better obtaining the effects of the present invention, the silicon material is more preferably silicon single crystal or polysilicon, and particularly preferably silicon single crystal. The polishing composition according to some embodiments of the present invention is particularly preferably used for polishing a substrate (e.g., a silicon wafer) having a surface made of silicon single crystal. Specifically, polishing composition according to the present aspect is preferably used for polishing an object to be polished containing a silicon material.

The silicon wafer to be polished using the polishing composition according to the present aspect may be either p-type or n-type. The crystal orientation of the silicon wafer is not particularly limited, and may be any of <100>, <110>, and <111>.

Furthermore, the shape of an object to be polished is not particularly limited. The polishing composition according to some embodiments of the present invention can be preferably applied to polishing of objects to be polished having flat surfaces, such as plate-shaped or polyhedral objects.

### [Polishing method]

As another aspect of the present invention, a polishing method comprising polishing an object to be polished using the polishing composition is provided. For example, according to one embodiment, a polishing method is provided comprising a step of polishing an object to be polished containing a silicon material using the polishing composition. The polishing composition according to the present aspect is particularly suitable for use in a final polishing step, since it has an excellent effect of reducing defects on the surface of an object to be polished. That is, the polishing method according to some embodiments of the present invention is suitable for use in the final polishing step. Therefore, according to the present invention, a method for producing an object to be polished (e.g., a method for producing a silicon wafer) including the final polishing step using the polishing composition is also provided. The final polishing step refers to the final polishing step in the process for producing the object (i.e., a step in which no further polishing is performed after the step). The polishing composition according to some embodiments of the present invention may also be used in a polishing step upstream of the final polishing step (refers to a step between a rough polishing step and the final polishing step), for example, a polishing step performed immediately before the final polishing step.

As described above, the polishing composition according to some embodiments of the present invention is preferably used for polishing silicon wafers. The polishing composition according to some embodiments of the present invention is particularly suitable as a polishing composition to be used in the final polishing step for silicon wafers. More specifically, the polishing composition according to some embodiments of the present invention is suitable for use in polishing silicon wafers that have been prepared to a surface state with a surface roughness of 0.01 nm or more and 100 nm or less by a step upstream of the final polishing step.

A polishing device that can be used herein is a general polishing device equipped with a holder for holding a substrate or the like having an object to be polished, a motor with a variable rotational speed, and the like, and a platen onto which a polishing pad (polishing cloth) can be attached.

As the polishing pad, a general nonwoven fabric type, a polyurethane type, a suede type, or the like can be used without particular restrictions. The polishing pad is preferably processed to have grooves for storing the polishing composition therein.

The polishing conditions are set appropriately depending on the stage of each polishing step in which the polishing composition is used.

In the stock polishing step, either a double-sided polishing machine or a single-sided polishing machine may be used, but the double-sided polishing machine can be suitably used. The rotational speed of the platen is usually about 10 rpm or more and 100 rpm or less, and suitably about 20 rpm or more and 50 rpm or less. When using the double-sided polishing machine, the rotational speeds of the upper and lower rotating platens may be different, but are usually set to the same relative speed with respect to the wafer. In addition, in the final polishing step, the single-sided polishing machine can be suitably used, and the rotational speed of the platen is usually about 10 rpm or more and 100 rpm or less, and suitably about 20 rpm or more and 50 rpm or less, and more suitably about 25 rpm or more and 50 rpm or less. At such a rotational speed, defects on the surface of an object to be polished can be reduced.

An object to be polished is usually pressurized by a platen. The pressure at this time can be selected as appropriate, but in the stock polishing step, the pressure is usually preferably about 5 kPa or more and 30 kPa or less, and more preferably about 10 kPa or more and 25 kPa or less. In the final polishing step, the pressure is usually preferably about 5 kPa or more and 30 kPa or less, and more preferably about 10 kPa or more and 20 kPa or less. Such a pressure can reduce defects on the surface of an object to be polished.

The supply flow rate of the polishing composition can also be appropriately selected depending on the size of the platen, but in terms of economy, in the case of the stock polishing step, the supply flow rate is usually preferably about 0.1 L/min or more and 5 L/min or less, and more suitably about 0.2 L/min or more and 2 L/min or less. In the case of the final polishing step, the supply flow rate is usually preferably about 0.1 L/min or more and 5 L/min or less, and more suitably about 0.2 L/min or more and 2 L/min or less. With such a supply flow rate, the surface of an object to be polished can be polished efficiently and defects on the surface of the object to be polished can be reduced.

The temperature for keeping the polishing composition in the polishing device is not particularly limited, but from the viewpoint of the stability of the polishing removal rate and the reduction of defects, the temperature is generally preferably 15°C or higher and 40°C or lower, and is more preferably about 18°C or higher and 25°C or lower.

The above polishing conditions (polishing device settings) are merely examples, and may be outside the above range, or the settings can also be changed as appropriate. Such conditions can be set as appropriate by those skilled in the art.

Furthermore, it is preferable to perform cleaning and drying after polishing. The methods and conditions of these operations are not particularly limited, and known methods and conditions may be appropriately employed. For example, an SC-1 cleaning solution (a mixture of ammonium hydroxide (NH₄OH), hydrogen peroxide (H₂O₂), and water (H₂O)), an SC-2 cleaning solution (a mixture of HCl, H₂O₂, and H₂O), ozone water cleaning solution, fluoric acid cleaning solution, and the like, which are common in the field of semiconductors, etc., can be used. The temperature of the cleaning solution can be, for example, in the range of room temperature (typically about 15°C to 25°C) or higher, up to about 90°C.

Although the embodiments of the present invention are described in detail, it is clear that these are illustrative and exemplary and are not limiting, and that the scope of the present invention should be interpreted by the appended claims.

The present invention includes the following aspects and embodiments.

[1] A polishing composition comprising (A) an abrasive, (B) Compound α having a polyethylene oxide structure and a polypropylene oxide structure, (C) a water soluble polymer different from the Compound α, (D) a basic compound, and (E) a dispersion medium, wherein the Compound α is contained in an amount of 0.0001 mass% or more relative to the total mass of the polishing composition, and the ratio of the total mass of (B) the Compound α and (C) the water soluble polymer to the mass of (A) the abrasive, [{(B)+(C)}/(A)], is 0.058 or more and less than 0.150.
[2] The polishing composition according to [1] above, wherein (C) the water soluble polymer comprises a water soluble polymer having a hydroxyl group.
[3] The polishing composition according to [1] or [2] above, wherein (C) the water soluble polymer comprises hydroxyethyl cellulose.
[4] The polishing composition according to [3] above, wherein (C) the water soluble polymers comprise hydroxyethyl cellulose and poly-N-acryloylmorpholine.
[5] The polishing composition according to [3] above, wherein (C) the water soluble polymers are hydroxyethyl cellulose and poly-N-acryloylmorpholine.
[6] The polishing composition according to [3] above, wherein (C) the water soluble polymers are hydroxyethyl cellulose and poly N-acryloylmorpholine, and the ratio of hydroxyethyl cellulose:poly N-acryloylmorpholine equals 70:30 to 99:1 (mass ratio).
[7] The polishing composition according to any one of [1] to [6] above, wherein (B) the Compound α is a PEO-PPO-PEO triblock copolymer.
[8] The polishing composition according to any one of [1] to [7] above, which is used for polishing an object to be polished containing a silicon material.
[9] A concentrated liquid of the polishing composition according to any one of [1] to [8] above.
[10] A polishing method comprising a step of polishing an object to be polished containing a silicon material using the polishing composition according to any one of [1] to [8] above.

### Examples

The present invention will be described in more detail using the following examples and comparative examples. However, the technical scope of the present invention is not limited to the following examples. Unless otherwise specified, "%" and "parts" mean "mass%" and "parts by mass", respectively.

### <Average primary particle size of abrasive>

The average primary particle size of abrasive was calculated from the specific surface area of the abrasive measured by the BET method and the density of the abrasives. The specific surface area of the abrasives measured by the BET method was measured using "Flow Sorb II 2300" manufactured by Micromeritics Instrument Corporation.

### <pH of Polishing composition>

The pH of the polishing composition was measured using a glass electrode type hydrogen ion concentration indicator (Model No: F-23, manufactured by Horiba, Ltd.). Three-point calibration was performed using as standard buffer solutions, a phthalate pH buffer solution (pH: 4.01 (25°C)), a neutral phosphate pH buffer solution (pH: 6.86 (25°C)), and a carbonate pH buffer solution (pH: 10.01 (25°C)). Thereafter, a glass electrode was placed in the polishing composition for 2 minutes or more. After the pH of the polishing composition was stabilized, the pH of the polishing composition was measured.

### [Raw materials for polishing composition]

The polishing compositions shown in Table 1 below were prepared using the following raw materials.

Abrasives
   - Abrasive a: colloidal silica average primary particle size: 35 nm (manufactured by Fuso Chemical Co., Ltd., product name "PL-3")
   - Abrasive b: colloidal silica average primary particle size: 25 nm (manufactured by Fuso Chemical Co., Ltd., product name "PL-2")
Compound α
   - EO-PO compound 1 (Compound α): Polyethylene oxide (PEO)-polypropylene oxide (PPO)-polyethylene oxide (PEO) triblock copolymer (weight average molecular weight (Mw) 3,000, molar ratio of ethylene oxide-derived group (EO) and propylene oxide-derived group (PO) = 160:30)
Water soluble polymer
   - Hydroxyethyl cellulose (HEC) (weight average molecular weight (Mw) 590,000)
   - Poly N-acryloylmorpholine (PACMO) (weight average molecular weight (Mw) 350,000)
Basic compound
   - Ammonia
Dispersion medium
   - Water

### [Preparation of Polishing Composition]

### Example 1

The above abrasive b as the abrasive, the above EO-PO compound 1 as Compound α, the above HEC and PACMO as the water soluble polymers, and ammonia as the basic compound were added to pure water as the dispersion medium at room temperature (25°C) to obtain a concentrated liquid. The concentrated liquid was stirred and mixed at room temperature (25°C) for 30 minutes, and then pure water as the dispersion medium was added to the mixture at the dilution ratio shown in Table 1 to prepare the polishing composition of Example 1. The content of each component shown in Table 1 is the blend amount after dilution. In the following Table 1, "mass ratio ((B+C)/A)" represents the mass ratio of the content of Compound α (B mass%) and the content of the water soluble polymer (C mass%) to the content of the abrasive (A mass%). In Example 1, HEC and PACMO were used as the water soluble polymers at a mass ratio of HEC:PACMO=19:1. The pH of the obtained polishing composition was 10.1.

### (Examples 2 to 10, Comparative Examples 1 to 5)

Polishing compositions of Examples 2 to 10 and Comparative Examples 1 to 5 were prepared in the same manner as in Example 1, except that the kinds and concentrations of the components were changed as shown in Table 1 below. The pH of each polishing composition was 10.1. The particle size of the abrasive in each polishing composition was the same as the particle size of the abrasive used. In Examples 2 to 10 and Comparative Examples 1 to 5, EO-PO compound 1 was used as Compound α, and only HEC was used as the water soluble polymer.

### [Polishing of silicon wafers]

The surface of a silicon wafer was stock-polished under the following polishing condition 1. The surface of the stock-polished silicon wafer was final-polished under the following polishing condition 2 using the polishing compositions of the Examples and Comparative Examples. Thereafter, the polished silicon wafer was removed from the polishing machine. The removed silicon wafer was cleaned using a single wafer processing cleaner. First, the silicon wafer was cleaned with an ozone water cleaning solution for 60 seconds, and then cleaned with an SC-1 cleaning solution and a brush for 110 seconds. Next, the silicon wafer was cleaned with an ozone water cleaning solution for 20 seconds, and then cleaned with a fluoric acid cleaning solution for 15 seconds. The silicon wafer was subjected to a total of three sets of cleaning, with the ozone water cleaning and fluoric acid cleaning being one set. The cleaned silicon wafer was further cleaned with an ozone water cleaning solution for 20 seconds. Thereafter, the silicon wafer was dried.

[Object to be polished]
   - Wafer: A p-type COP (Crystal Orginate 65d Particle)-free silicon wafer having a crystal orientation of <100> and a size of 300 mm was prepared.
[Stock polishing: polishing condition 1]
   - Polishing machine: PNX-332B (manufactured by Okamoto Machine Tool Works, Ltd.)
   - Polishing pad: POLYPAS275NX (manufactured by Fujibo Holdings, Inc.)
   - Polishing pressure: 10 kPa
   - Platen rotational speed: 30 rpm
   - Carrier rotational speed: 30 rpm
   - Polishing time: 2 min
   - Temperature of cooling water for platen: 20°C
   - Temperature of polishing composition: 20°C
   - Supply flow rate of polishing composition: 1 L/min
   - Polishing composition for stock polishing: polishing composition containing 1.0 mass% of abrasive (colloidal silica having an average primary particle size of 35 nm) and 0.06 mass% of potassium hydroxide in deionized water.
[Final polishing: polishing condition 2]
   - Polishing machine: PNX-332B (manufactured by Okamoto Machine Tool Works, Ltd.)
   - Polishing pad: POLYPAS275NX (manufactured by Fujibo Holdings, Inc.)
   - Polishing pressure: 12 kPa
   - Platen rotational speed: 30 rpm
   - Carrier rotational speed: 30 rpm
   - Polishing time: 2 min
   - Temperature of cooling water for platen: 20°C
   - Temperature of polishing composition: 20°C
   - Supply flow rate of polishing composition: 1.5 L/min
   - Polishing composition for final polishing: Polishing compositions of Examples and Comparative Examples shown in Table 1.

### [Evaluation]

### <Evaluation of the number of defects>

The dried silicon wafers were used for measuring the number of defects (LLS, Localized Light Scatterers) on the wafer surface. A wafer surface tester (manufactured by KLA Tencor Corporation, product name "SURFSCAN SP5") was used for measurement. The measurement mode was DCO mode. The following Table 1 shows the relative values (LLS ratios) of the number of defects in Examples 1 to 10 and Comparative Examples 2 to 4 to the number of defects (LLS) in Comparative Example 1. When the polishing composition of Comparative Example 5 was used, the number of defects on the silicon wafer surface after polishing was so large that the measurement was interrupted and no results were obtained (denoted as "Overload" in Table 1). In Table 1, the LLS pass/fail results were indicated as "Pass" for an LLS ratio of less than 100 and "Fail" for an LLS ratio of 100 or more.

### <Calculation of polishing removal rate>

The silicon wafers were subjected to stock polishing and final polishing in the same manner as in the evaluation of the number of defects.

The polishing removal rate was calculated by dividing the difference between the weight of the silicon wafer before and the same after final polishing [(weight before polishing) - (weight after polishing)] by the polishing time. The polishing removal rate of the silicon wafer using the polishing composition of Example 1 was 11 nm/min, and the polishing removal rate of the silicon wafer using the polishing composition of Example 8 was 9 nm/min. A silicon wafer polishing removal rate of 5 nm/min or more is practical.

**[Table 1]**

| | Abrasive | Abrasive | Compound α EO-PO Compound 1 | Second water soluble polymer HEC | Basic compound | Mass ratio | Dilution rate of concentrated liquid | Evaluation | |
|---|---|---|---|---|---|---|---|---|---|
| | Type | A | B | C | D | (B+C)/A | | LLS ratio | LLS pass/fail |
| | | Content (mass%) | Content (mass%) | Content (mass%) | Content (mass%) | | | | |
| Example 1 | b | 0.1690 | 0.0005 | 0.0094 (mass ratio HEC:PACMO=19:1) | 0.0046 | 0.0584 | 29 | 70 | Pass |
| Example 2 | b | 0.2750 | 0.0024 | 0.0170 | 0.0100 | 0.0704 | 20 | 76 | Pass |
| Example 3 | b | 0.1250 | 0.0015 | 0.0082 | 0.0050 | 0.0775 | 29 | 86 | Pass |
| Example 4 | a | 0.2366 | 0.0012 | 0.0172 | 0.0102 | 0.0780 | 29 | 84 | Pass |
| Example 5 | b | 0.1724 | 0.0012 | 0.0131 | 0.0069 | 0.0832 | 29 | 89 | Pass |
| Example 6 | b | 0.1252 | 0.0015 | 0.0092 | 0.0041 | 0.0858 | 29 | 98 | Pass |
| Example 7 | b | 0.1252 | 0.0015 | 0.0092 | 0.0059 | 0.0858 | 29 | 97 | Pass |
| Example 8 | b | 0.1252 | 0.0015 | 0.0103 | 0.0050 | 0.0941 | 29 | 79 | Pass |
| Example 9 | b | 0.1252 | 0.0012 | 0.0124 | 0.0050 | 0.1087 | 29 | 83 | Pass |
| Example 10 | b | 0.1252 | 0.0015 | 0.0124 | 0.0050 | 0.1112 | 29 | 70 | Pass |
| Comparative example 1 | a | 0.4600 | 0.0024 | 0.0170 | 0.0100 | 0.0421 | 20 | 220 | Fail |
| Comparative example 2 | a | 0.2366 | 0.0016 | 0.0094 | 0.0046 | 0.0465 | 29 | 100 | Fail |
| Comparative example 3 | b | 0.1750 | 0.0013 | 0.0072 | 0.0050 | 0.0480 | 20 | 230 | Fail |
| Comparative example 4 | b | 0.1250 | 0.0015 | 0.0050 | 0.0050 | 0.0520 | 29 | 172 | Fail |
| Comparative example 5 | b | 0.1252 | 0.0085 | 0.0103 | 0.0050 | 0.1500 | 29 | Overload | Fail |

As is clear from Table 1 above, the polishing compositions of the Examples can reduce the number of defects on the silicon wafer surface, and silicon wafers with good surface quality can be obtained. On the other hand, the polishing compositions of the Comparative Examples resulted in the increased number of defects, indicating that the surface quality of the silicon wafers is inferior to the other.

Therefore, it can be understood that the polishing composition according to the present aspect can improve the surface quality of an object to be polished after polishing.

The present application is based on Japanese Patent Application No. 2023-039981, filed on March 14, 2023, the disclosure of which is incorporated herein by reference in its entirety.

## Claims

1. A polishing composition comprising
(A) an abrasive,
(B) Compound α having a polyethylene oxide structure and a polypropylene oxide structure,
(C) a water soluble polymer different from the Compound α,
(D) a basic compound, and
(E) a dispersion medium,
wherein the Compound α is contained in an amount of 0.0001 mass% or more relative to the total mass of the polishing composition, and
the ratio of the total mass of (B) the Compound α and (C) the water soluble polymer to the mass of (A) the abrasive, [ {(B)+(C)}/(A)], is 0.058 or more and less than 0.150.

2. The polishing composition according to claim **1,** wherein (C) the water soluble polymer comprises a water soluble polymer having a hydroxyl group.

3. The polishing composition according to claim 1 or 2, wherein (C) the water soluble polymer comprises hydroxyethyl cellulose.

4. The polishing composition according to any one of claims 1 to 3, wherein (B) the Compound α is a PEO-PPO-PEO triblock copolymer.

5. The polishing composition according to any one of claims 1 to 4, which is used for polishing an object to be polished containing a silicon material.

6. A concentrated liquid of the polishing composition according to any one of claims 1 to 5.

7. A polishing method, comprising a step of polishing an object to be polished containing a silicon material using the polishing composition according to any one of claims 1 to 5.
